# EUROPEAN PATENT SPECIFICATION

(11) **EP 2 284 290 B1**
(45) Date of publication and mention of the grant of the patent: **03.08.2016**
(21) Application number: 09738776.5
(22) Date of filing: 27.04.2009
(51) Int. Cl.: C23C 4/06, B01J 19/00, C22C 21/00, C23C 14/00, C23C 16/44, H01L 21/205

(54) **WATER-REACTIVE AL COMPOSITE MATERIAL, WATER-REACTIVE AL FILM, METHOD FOR PRODUCTION OF THE AL FILM, AND STRUCTURAL MEMBER FOR FILM-FORMING CHAMBER**
GEGENÜBER WASSER REAKTIVER AL-VERBUNDWERKSTOFF, GEGENÜBER WASSER REAKTIVER AL-FILM, VERFAHREN ZUR HERSTELLUNG DES AL-FILMS UND BAUELEMENT FÜR FILMBILDUNGSKAMMER
MATÉRIAU COMPOSITE AL RÉAGISSANT À L'EAU, FILM AL RÉAGISSANT À L'EAU, PROCÉDÉ DE PRODUCTION DU FILM AL ET ÉLÉMENT STRUCTUREL POUR CHAMBRE DE FORMATION DE FILM

(30) Priority: 30.04.2008 JP 2008118854
(43) Date of publication of application: 16.02.2011
(73) Proprietor: Ulvac, Inc., Chigasaki-shi Kanagawa 253-8543 (JP)
(72) Inventor: KADOWAKI Yutaka, Chigasaki-shi Kanagawa 253-8543 (JP); SAITOU Tomoko, Chigasaki-shi Kanagawa 253-8543 (JP); LIM Keng Weng, Chigasaki-shi Kanagawa 253-8543 (JP); MUSHIAKE Katsuhiko, Sammu-shi Chiba 289-1297 (JP)
(74) Representative: AMMANN PATENTANWÄLTE AG BERN
(86) International application number: PCT/JP2009/058258
(87) International publication number: WO 2009/133839

(56) References cited:
- JP-A- 10 030 896
- JP-A- 62 080 287
- JP-A- 62 080 287
- JP-A- 62 263 946
- JP-A- 62 290 888
- JP-A- 2002 121 632
- JP-A- 2006 002 223
- US-A- 3 974 055
- US-A1- 2006 240 271

## Description

### Technical Field

The present invention relates to a water-reactive Al composite material, a water-reactive Al film, a process for the production of the Al film and a constituent member for a film-forming chamber and in particular to a water-reactive Al composite material using an Al raw material which contains Cu as an impurity thereof in a predetermined amount; a water-reactive Al film consisting essentially of this water-reactive Al composite material; a method for the production of this Al film; and a constituent member for a film-forming chamber, which is covered with this Al film.

### Background Art

In a film-forming apparatus for forming a thin film according to, for instance, the sputtering technique, the vacuum deposition technique, the ion-plating technique, or the CVD technique, a film of a metal or a metal compound, as a film-forming material, is inevitably adhered to a constituent member for a film-forming chamber, which is positioned within the film-forming apparatus during the film-forming process. As such constituent members for a film-forming chamber, there can be listed, for instance, an adhesion-preventive plate for inhibiting the adhesion of any film on the inner portions of a vacuum chamber other than a substrate, a shutter, a mask used for forming such a film only on the desired area on the substrate and a tray for conveying the substrate. A film having the same composition as that of the intended thin film (a thin film to be formed on a substrate) is also deposited on or adhered to these members during the film-forming process. In this respect, it is the usual practice that these members are repeatedly used after the removal of the film adhered thereto.

The film inevitably adhered to these constituent members for a film-forming chamber is thickened in proportion to the length of the working time of the film-forming process. Such an adhered film is peeled off, in the form of particles, from the constituent members for a film-forming chamber due to the action of the internal stress of the adhered film or the stress accumulated in the film through the repeated thermal hysteresis, and adhered to the substrate and this would accordingly result in the formation of a film having various defects. For this reason, it is the common practice that the constituent members for a film-forming chamber are subjected to the following cycle, at regular intervals; the removal or dismantlement thereof from the film-forming apparatus at a stage in which the adhered film is not yet peeled off, the washing thereof to remove the film adhered thereto, the subjection thereof to a surface-finishing treatment and the subsequent reuse thereof.

When using a valuable metal such as Al, Mo, Co, W, Pd, Nd, In, Ti, Re, Ta, Au, Pt, Se and Ag, as a film-forming material, there has been desired for the establishment of a processing technique for the recovery of metals which do not take part in the formation of the film thereof on the surface of a substrate and are adhered to the constituent members other than the substrate and for the development of a technique for making the members reusable.

For instance, in the case of the adhesion-preventive plate used for inhibiting the adhesion of any film-forming material onto, for instance, the inner wall of the film-forming apparatus and the surface of a variety of such constituent members for a film-forming chamber, other than the surface of a substrate, the deposit formed during the film-forming process is, in the existing circumstances, peeled off from the foregoing members and/or the inner wall, for the reuse thereof. Currently used as such a method for the peeling off of this deposit include, for instance, the sandblasting technique, the wet etching technique which makes use of an acid or an alkali and the peeling technique which uses the hydrogen embrittlement by the action of, for instance, hydrogen peroxide and even the peeling method which makes use of the electrolysis thereof. In this case, when implementing the treatment for peeling off of the deposit, the adhesion- preventive plate is damaged in a treating liquid in no small quantities and therefore, the adhesion-preventive plate would be limited in the number of reusable times. For this reason, there has been desired for the development of a film-peeling technique which can reduce the occurrence of any damage of the adhesion-preventive plate as low as possible.

In this respect, however, if the concentration of the peeled deposit present in the blasting waste generated during the foregoing sandblasting technique and in the waste liquor generated in the treatment with an agent such as an acid treatment or an alkali treatment is low, the cost required for the recovery of the valuable metals is correspondingly quite high and accordingly, this method is not profitable. In such case, the deposit thus peeled off is accordingly handled as waste, under the present conditions.

In the foregoing treatment with an agent, not only the cost for the agent per se is high, but also the cost required for the post-treatment of the used liquid containing such an agent is high and further the occurrence of any environmental pollution should be prevented. For this reason, there has been desired for the reduction of the amount of the foregoing agent to be used as low as possible. In addition, when carrying out the foregoing treatment with an agent, the film-forming material peeled off from the adhesion-preventive plate would be converted into other new chemical substances and therefore, the cost required for the recovery of only the film-forming material from the peeled deposit would further be piled up. Accordingly, the materials to be recovered are only the film-forming materials whose unit price is balanced with the recovery cost, in the existing circumstances.

In addition to the method for peeling off of the deposit, as has been discussed above, there has been known a technique for recovering valuable metals which comprises the steps of implementing a film-forming process in an apparatus provided with constituent members covered with an Al film consisting of a water-reactive Al composite material having such characteristic properties that it can undergo a reaction in a moisture-containing atmosphere and can thus be converted into substances soluble or active in water; peeling off and separating the film adhered to the Al film, during the film-forming process, through the reaction and/or dissolution of the Al film; and then recovering the valuable metals included in the film-forming material present in the adhered film thus peeled off (see, for instance, Patent Document 1 specified below) . In this respect, the water-reactive Al composite material is composed of Al or an Al alloy, and In, Sn, the combination of In and Sn or an alloy thereof.

### Prior Art Literature

### Patent Document

Patent Document 1: JP-A-2005-256063 (Claims).

### Disclosure of the Invention

### Problems That the Invention is to Solve

Accordingly, it is an object, in a broad sense, of the present invention to solve the foregoing problems associated with the conventional techniques and more specifically to provide an Al composite material using an Al raw material which contains Cu as an impurity thereof in an amount of not higher than 40 ppm, which can be made soluble through the reaction with water in a moisture-containing atmosphere; an Al film essentially consisting of this Al composite material; a method for the production of such an Al film; and a constituent member for a film-forming chamber, which is covered with this Al film.

### Means for the solution of the Problems

The water-reactive Al composite material according to the present invention is characterized in that it comprises an Al raw material selected from the group consisting of 2NAl to 5NA1 each containing Cu as an impurity of the Al raw material in an amount of not higher than 40 ppm, preferably not higher than 30 ppm and more preferably not higher than 10 ppm; and In in an amount ranging from 2 to 5% by mass on the basis of the mass of the Al raw material.

If the Al composite material has such a composition, the Al film prepared from this material can easily be dissolved in water in a moisture-containing atmosphere with the generation of hydrogen gas.

If the Al composite material is prepared using an Al raw material in which the amount of the contaminated Cu exceeds 40 ppm, the Al film prepared from such an Al composite material which has experienced high temperature thermal hysteresis is impaired in its solubility in water when the Al film repeatedly experiences thermal hysteresis and if the amount of the contaminant Cu further increases, the resulting Al film does not show any solubility in water, after all. In addition, if the amount of

In is less than 2% by mass the resulting Al film is deteriorated in its solubility in water, while if it exceeds 5% by mass the reactivity of the film becomes extremely high and the film often undergoes reaction with moisture within the atmosphere.

The water-reactive Al composite material of the present invention is further characterized by the addition, to the foregoing water-reactive Al composite material, of Si, including the Si as an impurity of the Al raw material, in a total amount ranging from 0.04 to 0.6% by mass and preferably 0.04 to 0.2% by mass for the Al-In system. This is because If the amount of Si is less than each lower limit, the additive only shows an impaired effect of controlling the reactivity of the resulting Al film with water, while if it exceeds each upper limit, the reactivity itself of the film with water is reduced.

The method for the production of the water-reactive Al film of the present invention is characterized in that it comprises the steps of melting a material which is prepared by incorporating, into an Al raw material selected from the group consisting of 2NA1 to 5NA1 whose contaminant Cu content is not higher than 40 ppm, preferably not higher than 30 ppm and more preferably not higher than 10 ppm,

In in an amount ranging from 2 to 5% by mass on the basis of the mass of the Al raw material, in such a manner that the resulting molten material has a uniform composition; thermally spraying the molten material on the surface of a base material; and then solidifying the sprayed molten material through quenching to thus form a film.

According to the present invention, the foregoing method is further characterized in that the Al composite material used for forming an Al film further comprises, on the basis of the mass of the Al raw material, Si (including the Si as an impurity of the Al raw material) in a total amount ranging from 0.04 to 0.6% by mass and preferably 0.04 to 0.2% by mass for the Al-In system.

The water-reactive Al film according to the present invention is characterized in that it consists essentially of the foregoing water-reactive Al composite material.

The constituent member for a film-forming chamber of a film-forming apparatus according to the present invention is characterized in that it is provided, on the surface, with the foregoing water-reactive Al film.

The aforementioned constituent member is characterized in that it is an adhesion-preventive plate, a shutter or a mask.

### Effects of the Invention

The Al film consisting essentially of the water-reactive Al composite material according to the present invention can easily be produced by a simple process such as the thermal spraying technique while lowering the cost of production. Moreover, the Al film has such characteristic properties that it can be dissolved in water through the reaction with water in a moisture-containing atmosphere, even after the film experiences a thermal hysteresis phenomenon as a result of the film-forming process carried out at a temperature ranging from about 300 to 350 °C and further the presence of a predetermined amount of Cu as an impurity of the Al material and the presence of a desired amount of Si incorporated therein would permit the control of the activity and/or solubility thereof before it experiences a thermal hysteresis phenomenon (or during the film-forming process). In addition, the Al film after it experiences a thermal hysteresis phenomenon can maintain the high solubility or activity in water.

This Al film can undergo a reaction with water in the presence of moisture and can effectively be dissolved in water while generating hydrogen gas. Accordingly, the following effects can be achieved by the Al composite film of the present invention: If the film-forming operation is carried out using a film-forming apparatus provided with constituent members for a film-forming chamber (for instance, an adhesion-preventive plate, a shutter and a mask), which are covered with the water-reactive Al film of the present invention, the inevitably adhered film consisting essentially of the film-forming material and adhered to the surface of, for instance, an adhesion-preventive plate during the film-forming process can be peeled off and/or separated from the surface through the reaction and/or dissolution of this Al film and the valuable metals included in the film-forming material can be easily recovered from the adhered film peeled off from the surface of the constituent members and the constituent members can thus be reused over an increased number of times.

The invention will be further explained by way of examples including preferred embodiments. The Figures show:

Fig. 1 is a graph showing the relation between the heat-treatment temperature (°C) and the reaction current density (mA/cm²), which is observed for the thermally sprayed Al film prepared in Example 1.
Fig. 2 is a graph showing the relation between the heat-treatment temperature (°C) and the reaction current density (mA/cm²), which is observed for the thermally sprayedAl film prepared in Example 2.
Fig. 3 is a photograph showing the adhered film (deposited film) peeled off from the base material provided thereon with the thermally sprayed Al film prepared in Example 2.

When producing a thin film in a film-forming apparatus according to a variety of film-forming techniques such as the sputtering technique, the interior of the film-forming chamber is subjected to the influence of repeated thermal hysteresis. For this reason, the surface of the constituent members such as an adhesion-preventive plate, which are positioned within the film-forming chamber and which are coated with the Al film of the present invention, is also subjected to the influence of repeated thermal hysteresis. Accordingly, it would be necessary that the Al film, at the time of the film-formation through the thermal spraying technique before the film is subjected to the influence of the thermal hysteresis, is not only stable, but also easy to handle. At the same time, the Al film provided thereon with adhered film inevitably attached thereto during the film-forming process should have such a solubility (or activity) that the Al film can easily be peeled off from the base material along with the adhered film and further should be stable, even after the Al film is influenced by the thermal hysteresis experienced in the film-forming process. In the case of the water-reactive Al film according to the present invention, such requirement for the solubility or activity would sufficiently be satisfied.

The upper limit of the thermal hysteresis temperature within the foregoing film-forming chamber is on the order of about 300 to 350 °C when the film is formed according to, for instance, the sputtering technique, the vacuum deposition technique, the ion-plating technique or the CVD technique. Therefore, it would in general be sufficient, from the practical standpoint, that the Al film has reactivity with water even after it is subjected to the influence of the thermal hysteresis up to a temperature of 300°C and it would be more suitable that the Al film preferably has reactivity with water even after the Al film experiences the thermal hysteresis up to a temperature of 350°C.

The foregoing solubility or activity of the Al composite film of the present invention is evaluated on the basis of the current density (in the present invention, also referred to as "reaction current density (mA/cm²)") as determined by immersing a base material covered with the Al film in warm water maintained at a predetermined temperature (ranging from 40 to 130°C and preferably 80 to 100°C) and then determining the current density of the immersion liquid. This determination method is one which comprises the steps of determining the loss in weight observed for each sample before and after the immersion thereof in the treating liquid and then converting the result into the current density value while taking into consideration, for instance, the surface area of the sample and the immersion time of the same in the treating liquid. It can be said that the Al film provided thereon with adhered film inevitably attached thereto during the film-forming process has such a solubility (or activity) that the Al film can easily be peeled off from the base material along with the adhered film even after the Al film is subjected to the influence of thermal hysteresis experienced in the film-forming process, so long as the reaction current density as determined according to this method is not less than 50 mA/cm².

The inventors of this invention have found that the solubility, in water, of a thermally sprayed Al film varies depending on the quantity of Cu present in the Al raw material as an impurity, in the process of investigating the dissolving ability of a variety of thermally sprayed Al films which have been subjected to the influence of thermal hysteresis.

The present invention will hereunder be described with reference to the following embodiments.

In the Al film consisting essentially of the water-reactive Al composite material according to the present invention, In and/or Bi is highly uniformly dispersed or distributed within the Al matrix which contains Cu as an impurity in a predetermined amount and accordingly, the Al film can easily react with water within a moisture-containing atmosphere such as water, water vapor or an aqueous solution and as a result, it can thus be made soluble or active in water.

Usable in the present invention as Al raw materials are, for instance, those having purities of 2N (99%), 3N (99.9%), 4N (99.99%) and 5N (99.999%). Each of 4NAl and 5NAl of them can be obtained by further treating 2NA1 or 3NAl prepared by the electrolytic process according to the three layer electrolytic process or a method according to the partial solidification technique (the segregation technique) which makes use of the temperature difference between the solid and liquid phases upon the solidification. The principal impurities present in these Al include Fe and Si and these Al raw materials further include, for instance, Cu, Ni and C as impurities other than the foregoing principal ones.

In the Al-In system, the electrochemical potential difference between Al and In in an Al-In system is in general quite high, but if the spontaneous oxide film of Al is present on the surface thereof, the ionization of Al is not advanced at all. However, when the spontaneous oxide film is once broken or removed and Al directly comes in close contact with In , the ionization of Al can be promoted very rapidly due to the potential difference between them. At this stage, In is, in the as- is status thereof, highly dispersed throughout the Al crystalline grains without causing any chemical change. In has a low melting point and never forms any solid-solution with Al. Accordingly, a desired Al film can be obtained by melting Al and In in such a manner that the composition thereof becomes uniform while taking care of the density difference between them and then thermally spraying the resulting molten material on the surface of a base material according to the thermal spraying technique to thus give an Al film, as a result of the solidification of the deposited molten material through quenching as well as the compressive effect of the solidification.

The added In is highly dispersed throughout the Al crystalline grains due to the action of the thermal spraying process and it is maintained in the state in which it comes in direct contact with Al. The added In never forms a stable phase along with Al and therefore, the Al/In interface is maintained in its high energy state and can undergo a vigorous reaction with water within a moisture-containing atmosphere at the contact surface with water. In addition, In as an added element is in a highly dispersed condition and the H₂ gas bubbles generated during the reaction undergo expansion to thus generate a mechanical action. Therefore, the reaction products mainly comprising AlOOH are finely pulverized on the surface, due to the mechanical action, without forming any film thereon and dispersed in the liquid and the reaction or the dissolution reaction continuously and explosively proceeds at the successively renewed reaction boundary.

The higher the purity of an Al raw material, the more conspicuous the behavior of the Al-In system described above and, in other words, the behavior is particularly conspicuous in the case of 4NAl and 5NAl as compared with 3NAl.

As has been discussed above, the contaminant Cu present in the Al raw material has a strong effect on the solubility, in water, of the thermally sprayed Al film obtained after subjecting it to thermal hysteresis, depending on the amount thereof. In this respect, if the Cu content is high and, in other words, if the content thereof exceeds 40 ppm, the resulting thermally sprayed Al film has an insufficient solubility in water after the film experiences high temperature thermal hysteresis and therefore, the Al film can be peeled off with great difficulty even when the temperature of the immersion water is increased in the treatment for peeling off of the deposited film. Moreover, if the Cu content falls within the range of from 30 to 40 ppm, the treatment for peeling off of the deposited film should be carried out while raising the temperature of the water used therefor (for instance, up to a level of not less than 100°C). On the other hand, if the Cu content is not higher than 30 ppm, the resulting Al film can satisfactorily be dissolved in water of a low temperature (for instance, not higher than 80°C) and accordingly, the deposited film can be removed. Furthermore, if the Cu content is not higher than 10 ppm, the solubility, in water, of the resulting Al film would further be improved even after the Al film is subjected to the influence of thermal hysteresis of a higher temperature (on the order of about 300 to 350°C).

Now, the present invention will be described with reference to the water-reactive Al composite material consisting essentially of a 4NAl-In or, for comparison, 4NAl-Bi. The thermally sprayed Al film is obtained using anAl-In or Al-Bi composite material wherein In or Bi is uniformly dispersed in 4NAl, according to a method which comprises the step of forming an intended film of the composite material on the surface of a base material to be treated in a predetermined atmosphere according to the thermal spraying technique. The resulting thermally sprayed Al-In or Al-Bi film comprises In or Bi crystalline grains (having a particle size of not more than 10 nm) in such a state that they are highly uniformly dispersed in the Al crystalline grains.

The foregoing thermally sprayed Al film can be prepared according to, for instance, the following procedures:

More specifically, the method comprises the steps of preparing 4NAl, as an Al raw material, whose amount of the contaminant Cu is not higher than 40 ppm, and In or Bi; incorporating, into the Al raw material, 2 to 5% by mass of In or 0.7 to 1.4% by mass of Bi, on the basis of the mass of the Al raw material to thus uniformly disperse or dissolve In or Bi in the Al raw material; forming the resulting uniform blend into a rod-like or wire-like article to be used as a material for thermal spraying; thermally spraying the material in a molten state on a base material serving as a constituent member for a film-forming chamber of a film-forming apparatus such as an adhesion-preventive plate for the chamber according to, for instance, the flame thermal spraying technique under the known thermal spraying conditions; and solidifying the sprayed molten material through quenching to thus give a base material provided thereon with a desired water-reactive thermally sprayed Al film. The thermally sprayed Al film thus produced is one in which In or Bi is present in the Al crystalline grains in its highly dispersed conditions.

According to another embodiment of the present invention, Si can be added to the foregoing Al-In or Al-Bi system to thus improve the characteristic properties of the resulting thermally sprayed Al film.

In the case of the thermally sprayed Al film produced using a composite material obtained by adding a predetermined amount of Si to an Al-In system, the solubility, in water, of the thermally sprayed Al film can be controlled without subjecting the Al film to any post-treatment and this accordingly prevents the thermally sprayed film from the dissolution through the reaction with the moisture present in the atmosphere and this also makes the handling of the film easier. Moreover, if the upper limit of the temperature during the thermal hysteresis phenomenon taking place within the film-forming chamber is on the order of about 300°C, anAl film showing practically acceptable activity or solubility in water can be produced using an Al composite material which comprises Si, incorporated therein, in an amount ranging from 0.04 to 0.6% by mass and preferably 0.05 to 0.5% by mass, while if the upper limit of the temperature during the thermal hysteresis phenomenon is high on the order of about 350°C, an Al film showing practically acceptable activity or solubility in water can be produced using an Al composite material which comprises Si, incorporated therein, in an amount ranging from 0.04 to 0.2% by mass and preferably 0.05 to 0.1% by mass.

In addition, the thermally sprayed Al film composed of an Al composite material obtained by incorporating a desired amount of Si into the foregoing Al-Bi system shows a low activity, it can thus easily be handled and the thermally sprayed Al film after it is subjected to the influence of thermal hysteresis is considerably improved in its activity and the film can thus show a high ability of dissolution (activity) in an atmosphere in which moisture is present. In addition, the thermally sprayed Al film may sometimes be converted into powder at ordinary temperature in the atmosphere within 2 to 3 hours, depending on the compositional ratio of Bi and Si in the film after the film experiences thermal hysteresis. Accordingly, the thermally sprayed Al film is preferably stored in an atmosphere free of any moisture (a vacuum atmosphere may likewise be used) in order to avoid the occurrence of the reaction thereof with the moisture in the atmosphere. In this respect, the film before experiencing thermal hysteresis may sometimes such a phenomenon that it is converted into powder depending on the compositional ratio of Bi and Si and accordingly, the film may likewise be stored in the same manner used above, in such case. In this connection, this situation is also true of the In-Si system.

Regarding the thermally sprayed Al film prepared from a material obtained by incorporating a desired amount of Si into anAl-In system, the Al film is produced using an Al-In-Si composite material, in which In and Si are uniformly dispersed in an Al raw material, according to a method which comprises the step of forming an intended film of the composite material on the surface of a base material to be treated in a predetermined atmosphere according to the thermal spraying technique. The resulting thermally sprayed Al-In-Si film comprises In in such a state that the In crystalline grains are highly uniformly dispersed in the Al crystalline grains.

The foregoing thermally sprayed Al film is, for instance, produced according to the method detailed below:

More specifically, the method for the preparation of the thermally sprayed Al film comprises the steps of preparing 4NAl, as an Al raw material, whose contaminant Cu content is not higher than 40 ppm, and In and Si; combining the 4NA1 with In, in an amount ranging from 2 to 5% by mass, and Si (inclusive of the contaminant Si present in the 4NAl) in a total amount ranging from 0.04 to 0.6% by mass and preferably 0.04 to 0.2% by mass, while taking into consideration the amount of Si present in the 4NAl as an impurity to thus uniformly disperse or dissolve the both In and Si in the Al raw material; forming the resulting uniform mixture into a rod-like or wire-like article to thus give a material for thermal spray; then covering the surface of a base material serving as a constituent member for a film-forming chamber of a film-forming apparatus such as an adhesion-preventive plate used in the chamber by thermally spraying the material in its molten state on the surface of the base material according to the flame thermal spraying technique; and subsequently solidifying, through quenching, the thermally sprayed material to thus give a base material provided thereon with a desired water-reactive thermally sprayed Al film. The thermally sprayed Al film thus formed is one in which In is present in Al crystalline grains in its highly, uniformly dispersed state, as has been described above.

When immersing the base material covered with the thermally sprayed Al film in warm water or spraying water vapor on the base material, as has been discussed above, for instance, when immersing the same in warm water whose temperature is set at a predetermined level, the reaction of the film with water is initiated immediately after the immersion, which is accompanied by the generation of hydrogen gas, the water is blackened as the reaction further proceeds because of the presence of, for instance, deposited In, finally the thermally sprayed film is completely dissolved and precipitates consisting of, for instance, Al and In remain in the warm water. This reaction vigorously proceeds with the increase in the temperature of the water.

The foregoing thermally sprayed film has been described above while taking, by way of example, one formed using a material having a rod-like or wire-like shape according to the flame-thermal spraying technique, but the Al film may likewise be formed using a powdery material according to the flame-thermal spraying technique. The film may further be formed according to the electric arc spraying technique, or the plasma spraying technique. In the present invention, the raw material described above is molten, followed by the spray of the molten material on the surface of a base material, quenching and solidifying the same to thus form a thermally sprayed film, according to one of these thermal spraying techniques, while using the known process conditions.

If using a base material, whose surface is covered with the foregoing water-reactive Al film, as a constituent member for a film-forming chamber such as an adhesion-preventive plate or a shutter which is positioned within the film-forming chamber of a film-forming apparatus, as has been discussed above, the film composed of the film-forming material inevitably adhered to the constituent member for a film-forming chamber can easily be peeled off from the constituent member after the completion of the film-forming process carried out over a predetermined number of times or cycles and accordingly, the valuable metals can be recovered from the peeled Al film provided thereon with the deposited film of the film-forming material, with ease.

In this case, used as a liquid for peeling off of the Al composite film is not any chemical reagent, but is water such as pure water, water vapor or an aqueous solution. Accordingly, it is possible to prevent the occurrence of any damage of the constituent member for a film-forming chamber such as an adhesion-preventive plate due to the dissolution of the latter in the liquid and these constituent members can be reused over a substantially increased number of times, as compared with that observed for the case in which a chemical reagent is used as such a liquid for peeling. Moreover, any chemical reagent is not used in the present invention and therefore, this would result in the considerable reduction of the cost required for the post-treatment and in the preservation of the environment. Furthermore, most of the film-forming materials adhered to the constituent members for a film-forming chamber such as an adhesion-preventive plate is never dissolved in water and accordingly, the present invention has such an advantage that a material can be recovered in the form of a solid having a composition and a shape substantially identical to those observed for the film-forming material. In addition, the present invention shows such an advantage that not only the recovery cost can be dramatically reduced, but also the process to be used for the recovery can be simplified and accordingly, wide variety of materials can be recovered according to the present invention. For instance, if the film-forming materials are expensive metals such as precious metals and rare metals, the use of a constituent member for a film-forming chamber such as an adhesion-preventive plate, which is provided, on the surface thereof, with a film consisting of the water-reactive Al composite material of the present invention, would permit the removal or peeling off of the film inevitably adhered to the constituent member during the film-forming operations and consisting of the film-forming material, simply by immersing the member in water or spraying water vapor on the same. This in turn permits the recovery of precious metals and rare metals without being accompanied by any contamination. Thus, the recovery cost can be reduced and the film-forming material can likewise be recovered while they are still in their high quality conditions.

The present invention will now be described in more detail below with reference to the following Working Examples.

### Example 1

The following Al-In compositions were prepared by incorporating In in 2NAl, 3NAl and 4NAl as Al raw materials, then thermally sprayed Al films were prepared using the resulting Al-In compositions and the resulting thermally sprayed Al films each were inspected for the relation between the Al purity of the Al raw material used in the composition, the contaminant Cu content in the Al raw material and the solubility or activity, in water, of the resulting thermally sprayed films and the results thus obtained were investigated and examined. In this connection, the added amount of In is expressed in terms of that relative to the mass (weight) of the Al raw material used.

2NAl (the amount of the contaminant Cu: <400 ppm) - 3% by mass (wt%) of In;
• 3NAl (the amount of the contaminant Cu: 70 ppm) - 3% by mass of In;
• 3NA1 (the amount of the contaminant Cu: less than the detection limit) - 3% by mass of In;
• 4NAl (the amount of the contaminant Cu: less than the detection limit) - 3% by mass of In.

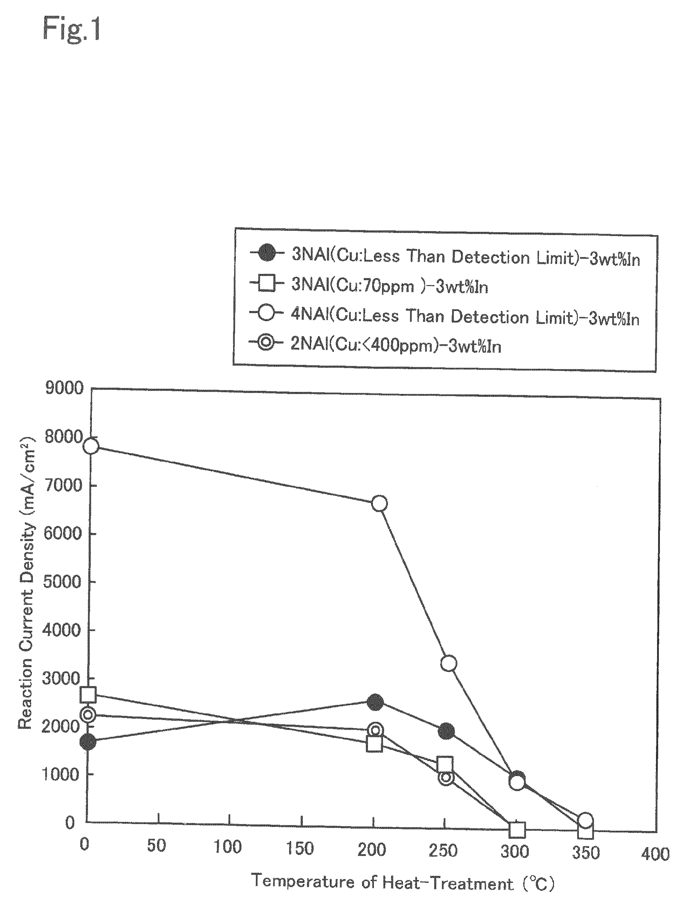

There were combined Al and In with each other at the rates specified above to thus uniformly dissolve or disperse In in the Al raw material and then each resulting blend was formed into a rod-like article and this article was used as a material for the thermal spraying process. Then a thermally sprayed film was formed by melting the rod-like article and then thermally spraying the resulting melt of the article on the surface of a base material made of aluminum in the atmosphere according to the rod flame spraying technique (heat source: C₂H₂-O₂ gas; temperature: about 3,000°C). Each of the thermally sprayed films thus produced was subjected to a heat-treatment at a temperature ranging from ordinary temperature to 350°C (the film was treated in the atmosphere for one hour and subsequently cooled within a furnace) in place of subjecting the film to the influence of thermal hysteresis possibly encountered during the film-forming process. Thereafter, the base material provided thereon with the thermally sprayed film prior to the heat-treatment (at ordinary temperature) and the same base material used above and obtained after the heat-treatment (one obtained after it had been subjected to the influence of thermal hysteresis) each were immersed in 300 mL of pure water maintained at 80°C, followed by the determination of the current density of each immersion liquid to estimate the solubility of each thermally sprayed film and the results thus obtained were investigated. The results thus obtained are plotted on Fig. 1. In Fig. 1, the heat-treatment temperature (°C) is plotted as abscissa and the reaction current density (mA/cm²) is plotted as ordinate.

The data plotted on Fig. 1 clearly indicate that the solubilities of the thermally sprayed Al films prepared using 2NAl to 4NAl as the Al raw materials fall within the range practically acceptable. The thermally sprayed Al film prepared using, as an Al raw material, 4NAl whose contaminant Cu content is less than the detection limit has solubility, in water, higher than those observed for the Al films produced using 2NAl and 3NAl as Al raw materials. In addition, the solubilities of the thermally sprayed Al films prepared using 3NAl and 4NAl as the Al raw materials whose contaminant Cu content is less than the detection limit were found to be soluble in water since the reaction current densities thereof are not less than 50 mA/cm² as observed when using a heat-treatment temperature of 350°C. However, the solubilities of the thermally sprayed Al films prepared using 2NAl and 3NAl as the Al raw materials whose contaminant Cu content is not less than 70 ppm were found to be insufficient even after the films were subjected to a heat-treatment of 350°C. In the latter case, the Al films could not be dissolved in water even if the temperature of the treating liquid was set at 100°C.

### Example 2

In this Example, the following Al-In compositions were prepared by incorporating In in 4NAl as an Al raw material, thermally sprayed Al films were then formed using the resulting Al-In compositions and the resulting Al films each were inspected for the relation between the contaminant Cu content in the Al raw material and the solubility, in water, of the resulting thermally sprayed films and the results thus obtained were investigated and examined. In this connection, the added amount of In is expressed in terms of that relative to the mass of the Al raw material used.

• 4NAl (the amount of the contaminant Cu: less than the detection limit) - 3% by mass of In;
• 4NAl (the amount of the contaminated Cu: <10 ppm) - 3% by mass of In;
• 4NAl (the amount of the contaminated Cu: 40 ppm) - 2.5% by mass of In;
• 4NAl (the amount of the contaminated Cu: 40 ppm) - 3% by mass of In;
• 4NAl (the amount of the contaminated Cu: 10 ppm) - 3% by mass of In;
• 4NAl (the amount of the contaminated Cu: 20 ppm) - 3% by mass of In;
• 4NAl (the amount of the contaminated Cu: 30 ppm) - 2.5% by mass of In.

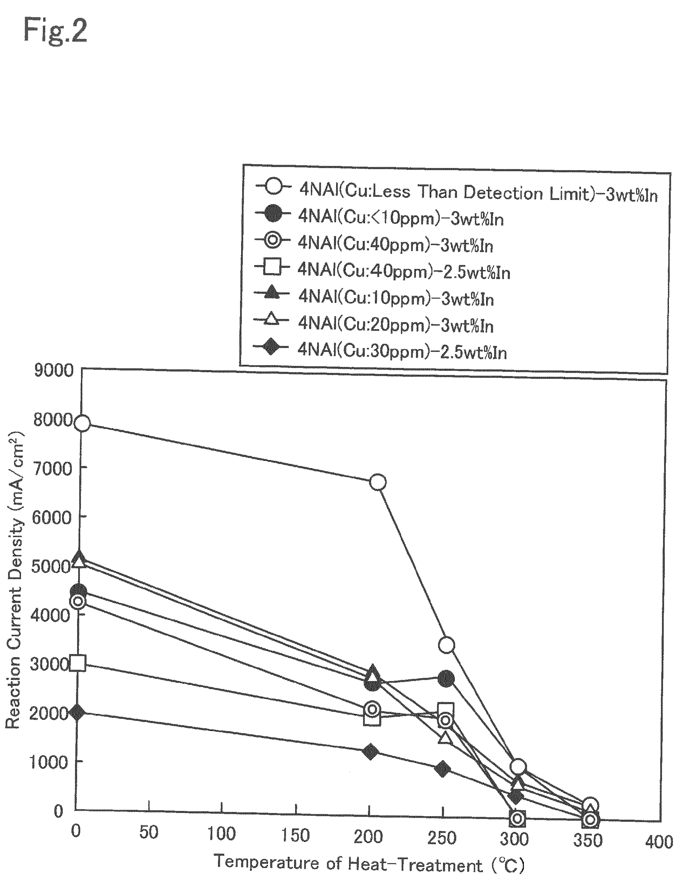

There were combined Al and In with each other at the rates specified above to thus uniformly dissolve or disperse In in the Al raw material and then each resulting blend was formed into a rod-like article and this article was used as a material for the thermal spraying process. Then a thermally sprayed film was formed by melting the rod-like article and then thermally spraying the resulting melt of the article on the surface of a base material made of aluminum in the atmosphere according to the rod flame spraying technique (heat source: C₂H₂-O₂ gas; temperature: about 3,000°C). Each of the thermally sprayed films thus produced was subjected to a heat-treatment at a temperature ranging from ordinary temperature to 350°C (the film was treated in the atmosphere for one hour and subsequently cooled within a furnace) in place of subjecting the film to the influence of thermal hysteresis possibly encountered during the film-forming process. Thereafter, the base material provided thereon with the thermally sprayed film prior to the heat-treatment (at ordinary temperature) and the same base material used above and obtained after the heat-treatment (one obtained after it had experienced thermal hysteresis) each were immersed in 300 mL of pure water maintained at 80°C, followed by the determination of the current density of each immersion liquid to evaluate the solubility of each thermally sprayed film and the results thus obtained were investigated. The results thus obtained are plotted on Fig. 2. In Fig. 2, the heat-treatment temperature (°C) is plotted as abscissa and the reaction current density (mA/cm²) is plotted as ordinate.

The data plotted on Fig. 2 clearly indicate that the solubilities of the thermally sprayed Al films prepared using 4NAl as the Al raw material certainly fall within the range practically acceptable since the reaction current density thereof is sufficiently high. If the Al raw material has a contaminant Cu content of less than 40 ppm, the resulting thermally sprayed Al films each were found to be soluble or active in water since they show a reaction current density of not less than 50 mA/cm² when carrying out the heat-treatment at a temperature ranging from 300 to 350°C. Moreover, the thermally sprayed Al film prepared using an Al raw material having a contaminant Cu content of 40 ppm was found to be insufficiently soluble in water when the heat-treatment was carried out at 350°C, while the same Al film obtained when the heat-treatment was carried out at 300°C was found to be sufficiently soluble in water since the reaction current density thereof was found to be not less than 50 mA/cm². Incidentally, when the temperature of the treating liquid was set at 100°C, the thermally sprayed Al film obtained after the heat-treatment of 350°C was found to be soluble.

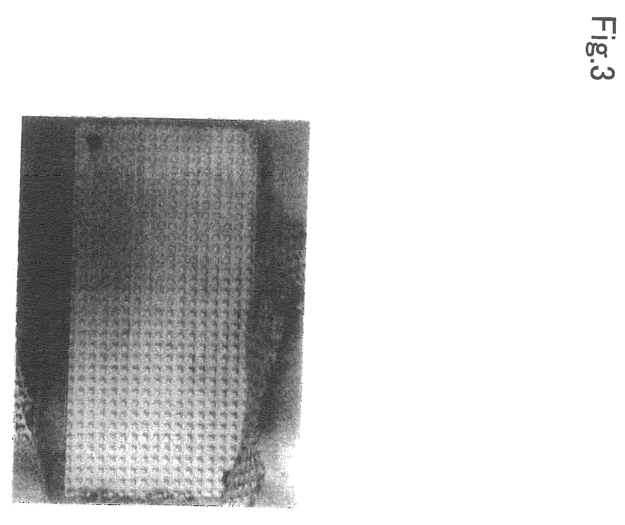

It was found that when immersing, in warm water maintained at 80°C, the base material covered with a thermally sprayed Al film having a good solubility in water and obtained after the foregoing heat-treatment, the reaction of the film with water is initiated immediately after the immersion, which is accompanied by the vigorous generation of hydrogen gas, the water is blackened as the reaction further proceeds because of the presence of, for instance, deposited In, finally the thermally sprayed film cannot maintain the state such that it is firmly adhered to the base material due to the reaction with water, and the film begins to be peeled off from the base material with dissolution. For instance, as shown in Fig. 3, the Al film containing added In was found to be completely peeled off from the base material. Thus, it can be said that the Al alloy film of the present invention is certainly water-reactive.

### Example 3

The following Al-In-Si compositions were prepared by incorporating In and Si (in a total amount including the amount of Si as an impurity) in 4NAl used as an Al raw material, thermally sprayed Al films were then prepared using the resulting Al-In-Si composition and the resulting thermally sprayed Al films each were inspected for the relation between the purity of the Al raw material used, the added amount of Si and the solubility, in water, of the resulting thermally sprayed films and the results thus obtained were investigated and examined. In this connection, the added amounts of In and Si are expressed in terms of those relative to the weight of the Al raw material used.

• 4NA1 (the amount of the contaminant Cu: not higher than 10 ppm) - 2% by mass of In - 0.05% by mass of Si;
• 4NAl (the amount of the contaminant Cu: not higher than 10 ppm) - 3% by mass of In - 0.1% by mass of Si;
• 4NAl (the amount of the contaminant Cu: not higher than 10 ppm) - 4% by mass of In - 0.5% by mass of Si;
• 5NAl (the amount of the contaminant Cu: not higher than 10 ppm) - 1.5% by mass of In - 0.05% by mass of Si;
• 5NAl (the amount of the contaminant Cu: not higher than 10 ppm) - 2.6% by mass of In - 0.1% by mass of Si;
• 5NAl (the amount of the contaminant Cu: not higher than 10 ppm) - 3.5% by mass of In - 0.5% by mass of Si.

There were combined Al, In and Si with each other at the rates specified above (in this respect, the amount of Si is expressed in terms of the amount including that of the contaminant Si) and the same procedures used in Example 1 were repeated except for using the resulting Al composite material to thus give thermally sprayed Al films. Then each of the thermally sprayed films thus produced was subjected to the same heat-treatment used in Example 1 (the film was treated in the atmosphere for one hour and subsequently cooled within a furnace). Thereafter, the base material provided thereon with the thermally sprayed film prior to the heat-treatment (at ordinary temperature) and the same base material used above and obtained after the heat-treatment (one obtained after it had experienced the thermal hysteresis) each were immersed in 300 mL of pure water maintained at 80°C, followed by the determination of the current density of each immersion liquid to estimate the solubility of each thermally sprayed film and the results thus obtained were investigated.

As a result, it was found that the addition of a predetermined amount of Si permits the control of the activity and, in other words, the solubility of the thermally sprayed film while the film is in the condition just after the formation thereof by the thermal spraying technique. Moreover, if the upper limit of the temperature of thermal hysteresis possibly experienced in the film-forming process is on the order of about 300°C, it was found that a thermally sprayed Al film having a practically acceptable activity or solubility in water can be produced using an Al composite material having an added In content of not less than 2% by mass and an added Si content ranging from 0.04 to 0.6% by mass. On the other hand, if the upper limit of the temperature of thermal hysteresis is high on the order of about 350°C, it was found that a thermally sprayed Al film having a practically acceptable activity or solubility in water can be produced using an Al composite material having an added In content of not less than 2% by mass and an added Si content ranging from 0.04 to 0.2% by mass.

### Example 4

Platinum (Pt) film-forming operations were repeated over 30 cycles using a sputtering apparatus provided with an adhesion-preventive plate whose surface had been covered with the thermally sprayed film of the 4NAl (the amount of the contaminant Cu: less than the detection limit) - 3% by mass of In prepared in Example 1; the thermally sprayed film of the 4NAl (the amount of the contaminant Cu: 40 ppm) - 2.5% by mass of In prepared in Example 2; the thermally sprayed film of the 4NAl (the amount of the contaminant Cu: not higher than 10 ppm) - 3% by mass of In - 0.1% by mass of Si prepared in Example 3
(each having a film thickness of 200µm). Thereafter, the adhesion-preventive plates to which the Pt film had been adhered were disassembled from the sputtering apparatus and treated with warm water maintained at 80°C. As a result, it was found that the thermally sprayed film is completely dissolved within about 30 minutes and that the Pt film deposited on the adhesion-preventive plate is peeled off from the same. Thus, Pt as the film-forming material could easily be recovered. At this stage, it was found that AlOOH is precipitated in the warm water.

### Industrial Applicability

If coating, with an Al film consisting of the water-reactive Al composite material according to the present invention, the surface of constituent members for a film-forming chamber of a vacuum film-forming apparatus, which is used in forming a thin film of a metal or a metal compound according to the sputtering technique, the vacuum deposition technique, the ion-plating technique and the CVD technique, the film inevitably adhered, during the film-forming process, to the surface of such a constituent member for a film-forming chamber can be peeled off therefrom in a moisture-containing atmosphere and can easily be recovered. Therefore, the present invention can be used in the fields in which these film-forming apparatuses are employed, for instance, in the technical fields related to semiconductor elements and electronics-related machinery and tools for the purpose of increasing the number of reuse times of the constituent members for a film-forming chamber of a film-forming apparatus and of recovering the film-forming materials which contains valuable metals.

## Claims

1. A water-reactive Al composite material comprising an Al raw material selected from the group consisting of 2NAl to 5NA1 each containing Cu as an impurity of Al in an amount of not higher than 40 ppm; and in an amount ranging from 2 to 5 % by mass on the basis of the mass of Al and further comprising Si, including the Si as an impurity of the Al raw material, in a total amount ranging from 0.04 to 0.6% by mass. .

2. A method for the production of a water-reactive Al film comprising the steps of melting a material which is prepared by incorporating, into an Al raw material selected from the group consisting of 2NAl to 5NAl whose contaminant Cu content is not higher than 40 ppm, in an amount ranging from 2 to 5 % by mass and further Si, including the Si as an impurity of the Al raw material, in a total amount ranging from 0.04 to 0.6 % by mass on the basis of the mass of the Al raw material, in such a manner that the resulting molten material has a uniform composition; forming a material having a rod-like, wire-like or powder-like shape of the resulting blended material;performing flame-thermal spraying using the material having the rod-like, wire-like or powdery-like shape on the surface of a base material; and then solidifying the same through quenching to thus form a film.

3. A method for the production of a water-reactive Al film comprising the steps of electric arc spraying or plasma spraying a water-reactive Al composite material which is prepared by incorporating, into an Al raw material selected from the group consisting of 2NA1 to 5NAl whose contaminant Cu content is not higher than 40 ppm, in an amount ranging from 2 to 5 % by mass and further Si, including the Si as an impurity of the Al raw material, in a total amount ranging from 0.04 to 0.6 % by mass on the basis of the mass of the Al raw material, in such a manner that the resulting molten material has a uniform composition, on the surface of a base material; and then solidifying the same through quenching to thus form a film.

4. A water-reactive Al film consisting essentially of the water-reactive Al composite material as set forth in claim 1.

5. A constituent member for a film-forming chamber of a film-forming apparatus **characterized in that** it is provided thereon with a water-reactive Al film consisting essentially of a water-reactive Al composite material as set forth in claim 1 or a water-reactive Al film prepared according to the method as set forth in claim 2 or 3.

6. The constituent member for a film-forming chamber as set forth in claim 5, wherein the constituent member is an adhesion-preventive plate, a shutter or a mask.

7. The method for the production of a water-reactve Al film as set forth in claim 2 or 3, wherein the water-reactive Al film has such characteristic properties that it can be dissolved in water through the reaction with water in a moisture-containing atmosphere, even after the water-reactive Al film experiences a thermal hysteresis phenomenon as the result of the film-forming process carried out at a temperature ranging from 300 to 350 °C.

8. The water-reactive Al film as set forth in claim 4, wherein the water-reactive Al film has such characteristic properties that it can be dissolved in water through the reaction with water in a moisture-containing atmosphere, even after the water-reactive Al film experiences a thermal hysteresis phenomenon as a result of the film-forming process carried out at a temperature ranging from 300 to 350 °C.

9. The constituent member for a film-forming chamber of a film-forming apparatus as set forth in claim 5 or 6, wherein the water-reactive Al film has such characteristic properties that it can be dissolved in water through the reaction with water in a moisture-containing atmosphere, even after the water-reactive Al film experiences a thermal hysteresis phenomenon as a result of the film-forming process carried out at a temperature ranging from 300 to 350 °C.

## Patentansprüche

1. Wasserreaktives Al-Verbundmaterial, enthaltend ein aus der Gruppe bestehend aus 2NA1 bis 5NAl ausgewähltes Al-Rohmaterial, das jeweils Cu als Verunreinigung des Al in einer Menge nicht über 40 ppm enthält; sowie In in einer Menge im Bereich von 2 bis 5 Massenprozent, bezogen auf die Masse des Al, und ferner Si, einschliesslich des als Verunreinigung im Al-Rohmaterial enthaltenen Si, in einer Gesamtmenge im Bereich von 0,04 bis 0,6 Massenprozent.

2. Verfahren zur Herstellung eines wasserreaktiven Al-Films, umfassend als Schritte das Schmelzen eines Materials, das hergestellt wird durch Zugeben zu einem aus der Gruppe bestehend aus 2NA1 bis 5NA1 ausgewählten Al-Rohmaterial, dessen Gehalt an Cu-Verunreinigung nicht mehr als 40 ppm beträgt, von In in einer Menge im Bereich von 2 bis 5 Massenprozent und ferner von Si, einschliesslich des als Verunreinigung im Al-Rohmaterial enthaltenen Si, in einer Gesamtmenge im Bereich von 0,04 bis 0,6 Massenprozent bezogen auf die Masse des Al-Rohmaterials derart, dass das resultierende geschmolzene Material eine gleichförmige Zusammensetzung aufweist; das Bilden eines Materials in stabähnlicher, drahtähnlicher oder pulverähnlicher Form aus dem resultierenden gemischten Material; das Flammspritzen des Materials in stabähnlicher, drahtähnlicher oder pulverähnlicher Form auf die Oberfläche eines Grundmaterials; und das anschliessende Verfestigen desselben durch Abschrecken, um so einen Film zu bilden.

3. Verfahren zur Herstellung eines wasserreaktiven Al-Films, umfassend als Schritte das Lichtbogenspritzen oder Plasmaspritzen eines wasserreaktiven Al-Verbundmaterials, das hergestellt wird durch Zugeben zu einem aus der Gruppe bestehend aus 2NA1 bis 5NAl ausgewählten Al-Rohmaterial, dessen Gehalt an Cu-Verunreinigung nicht mehr als 40 ppm beträgt, von In einer Menge im Bereich von 2 bis 5 Massenprozent und ferner von Si, einschliesslich des als Verunreinigung im Al-Rohmaterial enthaltenen Si, in einer Gesamtmenge im Bereich von 0,04 bis 0,6 Massenprozent bezogen auf die Masse des Al-Rohmaterials derart, dass das resultierende geschmolzene Material eine gleichförmige Zusammensetzung aufweist, auf die Oberfläche eines Grundmaterials; und das anschliessende Verfestigen desselben durch Abschrecken, um so einen Film zu bilden.

4. Wasserreaktiver Al-Film, im Wesentlichen bestehend aus dem wasserreaktiven Al-Verbundmaterial nach Anspruch 1.

5. Bestandteil für eine Filmbildungskammer einer Filmbildungsvorrichtung, **dadurch gekennzeichnet, dass** darauf ein im Wesentlichen aus einem wasserreaktiven Al-Verbundmaterial nach Anspruch 1 bestehender wasserreaktiver Al-Film oder ein gemäss dem Verfahren nach Anspruch 2 oder 3 hergestellter Al-Film aufgebracht ist.

6. Bestandteil für eine Filmbildungskammer nach Anspruch 5, wobei der Bestandteil eine haftungsverhindernde Platte, ein Verschluss oder eine Maske ist.

7. Verfahren zur Herstellung eines wasserreaktiven Al-Films nach Anspruch 2 oder 3, wobei der wasserreaktive Al-Film solche charakteristische Eigenschaften aufweist, dass er durch die Reaktion mit Wasser in einer feuchtigkeitshaltigen Atmosphäre auch dann noch wasserlöslich ist, wenn der wasserreaktive Al-Film infolge des bei einer Temperatur im Bereich von 300 bis 350 °C durchgeführten Filmbildungsverfahrens einem thermischen Hysteresephänomen unterliegt.

8. Wasserreaktiver Al-Film nach Anspruch 4, wobei der wasserreaktive Al-Film solche charakteristische Eigenschaften aufweist, dass er durch die Reaktion mit Wasser in einer feuchtigkeitshaltigen Atmosphäre auch dann noch wasserlöslich ist, wenn der wasserreaktive Al-Film infolge des bei einer Temperatur im Bereich von 300 bis 350 °C durchgeführten Filmbildungsverfahrens einem thermischen Hysteresephänomen unterliegt.

9. Bestandteil für eine Filmbildungskammer einer Filmbildungsvorrichtung nach Anspruch 5 oder 6, wobei der wasserreaktive Al-Film solche charakteristische Eigenschaften aufweist, dass er durch die Reaktion mit Wasser in einer feuchtigkeitshaltigen Atmosphäre auch dann noch wasserlöslich ist, wenn der wasserreaktive Al-Film infolge des bei einer Temperatur im Bereich von 300 bis 350 °C durchgeführten Filmbildungsverfahrens einem thermischen Hysteresephänomen unterliegt.

## Revendications

1. Matériau composite Al réactif à l'eau, constitué d'une matière première Al choisie parmi le groupe comprenant 2NA1 à 5NA1 contenant chaque fois du Cu en tant qu'impureté de l'Al en une quantité ne dépassant pas 40 ppm; et de l'In en une quantité dans la plage de 2 à 5 % en masse, sur la base de la masse de l'Al, et contenant en plus du Si, y inclus le Si contenu en tant qu'impureté de la matière première Al, en une quantité totale dans la plage de 0,04 à 0,6 % en masse.

2. Procédé de production d'un film Al réactif à l'eau, comprenant les étapes consistant à fondre un matériau préparé en incorporant, dans une matière première Al choisie parmi le groupe comprenant 2NAl à 5NAl dont le contenu en Cu contaminant ne dépasse pas 40 ppm, de l'In en une quantité dans la plage de 2 à 5 % en masse et en plus du Si, y inclus le Si contenu en tant qu'impureté de la matière première Al, en une quantité totale dans la plage de 0,04 à 0,6 % en masse, sur la base de la masse de la matière première Al, de telle manière que le matériau fondu résultant a une composition uniforme; à former un matériau en forme de tige, de fil ou de poudre à partir du matériau mélangé résultant; à effectuer la projection thermique flamme avec le matériau en forme de tige, de fil ou de poudre sur la surface d'un matériau de base; et à le solidifier ensuite par trempe afin de former ainsi un film.

3. Procédé de production d'un film Al réactif à l'eau, comprenant les étapes consistant à projeter à l'arc électrique ou au plasma un matériau composite Al réactif à l'eau préparé en incorporant, dans une matière première Al choisie parmi le groupe comprenant 2NAl à 5NAl dont le contenu en Cu contaminant ne dépasse pas 40 ppm, de l'In en une quantité dans la plage de 2 à 5 % en masse et en plus du Si, y inclus le Si contenu en tant qu'impureté de la matière première Al, en une quantité totale dans la plage de 0,04 à 0,6 % en masse, sur la base de la masse de la matière première Al, de telle manière que le matériau fondu résultant a une composition uniforme, sur la surface d'un matériau de base; et à le solidifier ensuite par trempe afin de former ainsi un film.

4. Film Al réactif à l'eau essentiellement constitué du matériau composite Al réactif à l'eau selon la revendication 1.

5. Composant pour une chambre de formation de film d'un dispositif de formation de film, **caractérisé en ce qu'**il est revêtu d'un film Al réactif à l'eau essentiellement constitué d'un matériau composite Al réactif à l'eau selon la revendication 1 ou d'un film Al réactif à l'eau préparé suivant le procédé selon la revendication 2 ou 3.

6. Composant pour une chambre de formation de film selon la revendication 5, où le composant est une plaque antiadhésive, un obturateur ou un masque.

7. Procédé de production d'un film Al réactif à l'eau selon la revendication 2 ou 3, où le film Al réactif à l'eau a de telles propriétés caractéristiques qu'il est toujours soluble dans l'eau en réagissant avec l'eau dans une atmosphère contenant de l'humidité même après avoir subi un phénomène d'hystérésis thermique suite au procédé de formation de film mis en oeuvre à une température dans la plage de 300 à 350 °C.

8. Film Al réactif à l'eau selon la revendication 4, où le film Al réactif à l'eau a de telles propriétés caractéristiques qu'il est toujours soluble dans l'eau en réagissant avec l'eau dans une atmosphère contenant de l'humidité même après avoir subi un phénomène d'hystérésis thermique suite au procédé de formation de film mis en oeuvre à une température dans la plage de 300 à 350 °C.

9. Composant pour une chambre de formation de film d'un dispositif de formation de film selon la revendication 5 ou 6, où le film Al réactif à l'eau a de telles propriétés caractéristiques qu'il est toujours soluble dans l'eau en réagissant avec l'eau dans une atmosphère contenant de l'humidité même après avoir subi un phénomène d'hystérésis thermique suite au procédé de formation de film mis en oeuvre à une température dans la plage de 300 à 350 °C.
